(19) Europäisches Patentamt

European Patent Office

Office européen des brevets

(11) **EP 1 227 329 B1**

(12) **FASCICULE DE BREVET EUROPEEN**

(45) Date de publication et mention
de la délivrance du brevet:
**14.04.2004 Bulletin 2004/16**

(51) Int Cl.⁷: **G01R 31/04**

(21) Numéro de dépôt: **02290165.6**

(22) Date de dépôt: **23.01.2002**

(54) **Circuit de détection de mauvaise connexion d'alimentation**

Detektorschaltung für Fehlverbindung an einer Stromversorgung

Detector circuit for a poor power supply connection

(84) Etats contractants désignés:
**DE FR GB IT**

(30) Priorité: **30.01.2001 FR 0101253**

(43) Date de publication de la demande:
**31.07.2002 Bulletin 2002/31**

(73) Titulaire: **STMicroelectronics S.A.**
**92120 Montrouge (FR)**

(72) Inventeurs:
• **Moreaux, Christophe**
**13100 Aix-en-Provence (FR)**
• **Kari, Ahmed**
**13100 Aix-en-Provence (FR)**

(74) Mandataire: **Ballot, Paul**
**Cabinet Ballot**
**122, rue Edouard Vaillant**
**92593 Levallois-Perret Cedex (FR)**

(56) Documents cités:
• **PATENT ABSTRACTS OF JAPAN vol. 1995, no. 02, 31 mars 1995 (1995-03-31) & JP 06 325222 A (FUJI ELECTRIC CO LTD), 25 novembre 1994 (1994-11-25)**
• **PATENT ABSTRACTS OF JAPAN vol. 2000, no. 16, 8 mai 2001 (2001-05-08) & JP 2001 005916 A (MATSUSHITA ELECTRIC IND CO LTD), 12 janvier 2001 (2001-01-12)**
• **PATENT ABSTRACTS OF JAPAN vol. 013, no. 570 (P-977), 18 décembre 1989 (1989-12-18) & JP 01 237894 A (HITACHI MAXELL LTD), 22 septembre 1989 (1989-09-22)**

**Description**

La présente invention concerne un circuit de détection de mauvaise connexion d'alimentation. L'invention s'applique notamment au domaine des cartes à puce.

Si on prend l'exemple d'une carte à puce, le circuit intégré de cette carte reçoit ses alimentations externes, typiquement Vdd et Gnd, d'un coupleur ou lecteur. Cette liaison carte/coupleur peut être de mauvaise qualité, avec des résistances série de contact qui peuvent être très importantes. La qualité de la liaison peut en effet être affectée par l'usure ou la corrosion des plots du circuit intégré. Une autre cause de dégradation de la liaison carte/coupleur, est la fraude : un tiers mal intentionné peut en effet délibérément dégrader cette liaison, par exemple en plaçant de l'adhésif sur un ou plusieurs plots de la carte, dans le but de provoquer un fonctionnement anormal de cette carte.

Lorsque la liaison carte/coupleur se fait mal au niveau des plots d'alimentation, l'alimentation interne du circuit intégré peut se faire indirectement par des plots d'entrées/sorties du circuit intégré, via des éléments de tirage (résistances, diodes) connectés entre ces plots et une tension interne d'alimentation. Ceci peut entraîner des dysfonctionnements graves du circuit intégré.

Prenons par exemple le cas d'un circuit intégré comprenant deux plots d'alimentation pour recevoir d'un coupleur la masse Gnd et une tension d'alimentation logique Vdd, et au moins un plot d'entrée/sortie avec un élément de tirage à la masse Gnd, par une résistance que l'on note Rpd. Ce plot reçoit par défaut du coupleur un niveau correspondant à la masse. Il peut changer de niveau sur des temps très courts, correspondants à des impulsions d'horloge de la liaison circuit/coupleur.

Par défaut, le circuit intégré est dans un premier mode de fonctionnement, dans lequel il consomme un courant I1 (par exemple, dans un mode lecture en mémoire). Sur commande du coupleur, il peut passer dans un deuxième mode de fonctionnement dans lequel il consomme un courant supérieur I2 (par exemple, dans un mode écriture en mémoire).

Enfin, un tel circuit intégré comprend habituellement un dispositif de ré-initialisation (*Power On Reset selon la terminologie anglo-saxonne*) en fonction de la différence de potentiel entre les niveaux internes de la tension d'alimentation logique et de la masse dans le circuit intégré. Ce dispositif est actif à la mise sous tension et hors tension du circuit. Notamment, il s'active à chaque fois que la différence de potentiel entre les niveaux internes de la tension d'alimentation logique et de la masse descend en dessous d'un seuil déterminé, que l'on note Vpor. On suppose dans l'exemple que le seuil Vpor est fixé à 4 volts pour une tension d'alimentation logique Vdd de 5 volts.

Supposons que le plot d'alimentation associé à la masse Gnd présente une très grande résistance série de contact. La masse Gnd n'est pas transmise correctement en interne du circuit intégré par ce plot. Le plot d'entrée/sortie qui est à la masse, amène la ligne de masse interne à un niveau de tension Va par le dispositif de tirage associé.

Si le circuit intégré est dans le premier mode de fonctionnement, ce niveau interne de masse Va obtenu par la résistance de tirage Rpd est égal à Rpd.I1.

Dans ces conditions, le circuit intégré pourra correctement fonctionner dans ce premier mode de fonctionnement, à la condition que le niveau interne V1 de masse soit tel que la différence de potentiel entre le niveau interne Vddint de la tension d'alimentation logique Vdd et ce niveau interne de la masse reste supérieur au seuil de réinitialisation Vpor, ce qui s'écrit :

$$Vddint - Va > Vpor \; ; \; soit \; Vddint - Rpd.I1 > Vpor.$$

Si le circuit intégré passe dans le deuxième mode de fonctionnement, le niveau interne Va de la masse passe à un niveau supérieur (I2>I1), égal à Rpd.I2.

On peut alors se retrouver dans une situation telle que la différence de potentiel entre les niveaux interne de la tension d'alimentation logique Vdd et de la masse Gnd devienne inférieure au seuil Vpor de ré-initialisation du circuit intégré, ce qui va bloquer le circuit intégré. Comme ce changement de situation n'est pas immédiat, il se peut qu'une partie de la commande liée au deuxième mode de fonctionnement (écriture en mémoire) soit exécutée. Ce qui est encore plus pénalisant.

Un objet de l'invention est de détecter que la connexion des alimentations du circuit intégré est mauvaise.

Un objet de l'invention est de détecter la présence de résistances série de contact importantes sur les plots d'alimentation.

Un objet de l'invention est de détecter que l'alimentation du circuit intégré ne se fait pas par des dispositifs de tirage de plots d'entrée/sortie du circuit intégré.

Le document JP-A-2001005916 (D1) se rapporte également au problème qui se pose dans la présente invention et concerne plus particulièrement la prévention de dysfonctionnement d'une carte à puce du fait d'un contact d'alimentation défectueux. Cependant, la solution proposée dans D1 est une solution très complexe, puisqu'elle consiste en des moyens de détection comprenant un microprocesseur CPU, une mémoire et un convertisseur A/N pour comparer le niveau du signal de commande transmis par la carte sur la ligne de communication, à un niveau de référence déterminé, dans des conditions opérationnelles particulières (ligne de réinitialisation à 0 et sur le niveau bas du signal sur la ligne d'horloge). Ces moyens de comparaison sont prévus dans le lecteur de carte et ne sont nullement prévus pour être implémentés dans un circuit intégré. De plus, les moyens mis en oeuvre par D1 ne permettent pas d'assurer une couverture optimale en termes de protection du circuit intégré.

Selon l'invention, on prévoit, par plot d'alimentation du circuit intégré auquel est associée une ligne interne d'alimentation, au moins un dispositif de comparaison de niveaux de tension entre ladite ligne d'alimentation interne du circuit intégré et un plot d'entrée/sortie du circuit intégré, ce plot comprenant un dispositif de tirage connecté entre ce plot et cette ligne d'alimentation interne.

Si le niveau de tension sur la ligne d'alimentation interne est imposé par le dispositif de tirage, ce niveau peut être supérieur ou inférieur au niveau de tension du plot. Selon que cette différence est supérieure ou inférieure à un seuil de détection prédéterminé, on en déduit que l'alimentation est bien ou mal connectée. Dans le cas où l'alimentation est détectée comme étant mal connectée, on prévoit que le circuit intégré bloque son propre fonctionnement. Le dispositif de détection selon l'invention agit alors comme un dispositif de sécurité, empêchant tout dysfonctionnement dans le circuit intégré qui serait dû à une mauvaise connexion d'alimentation.

En pratique, on prévoit que le dispositif de détection selon l'invention comprend un circuit de comparaison associé à chaque niveau interne d'alimentation. Si, pour un niveau de tension d'alimentation donné, il existe plusieurs plots d'entrée/sortie avec un dispositif de tirage à ce niveau de tension, on prévoit de préférence un dispositif de comparaison pour chacun de ces plots.

Un dispositif de détection selon l'invention est particulièrement indiqué pour lutter activement contre les tentatives de fraude visant à provoquer des fonctionnements anormaux du circuit intégré.

Il s'applique également dans les cas d'utilisation normale du circuit intégré, pour détecter l'usure ou la corrosion des plots d'alimentation. Dans ce type d'application, le dispositif de détection sera de préférence utilisé en combinaison avec des circuits de protection qui peuvent exister sur les plots d'entrée/sortie eux-mêmes. En effet, ces plots d'entrée/sortie pouvant être eux-mêmes usés ou corrodés, du fait de l'utilisation normale du circuit intégré, le niveau transmis par ces plots peut être altéré et les résultats en sortie du dispositif de détection selon l'invention doivent alors être considérés en combinaison avec d'autres informations de sécurité.

Telle que revendiquée, l'invention concerne donc un dispositif de détection de mauvaise connexion d'alimentation dans un circuit intégré. Selon l'invention, dans un circuit intégré comportant au moins un plot d'alimentation pour appliquer une alimentation externe sur une ligne interne d'alimentation du circuit intégré et au moins un plot d'entrée/sortie auquel est associé un dispositif de tirage connecté entre ledit plot et la dite ligne d'alimentation interne, ce dispositif de détection comprend un circuit de comparaison des niveaux de tension entre ledit plot et la dite ligne d'alimentation interne.

Le signal délivré par le dispositif de détection peut être utilisé pour bloquer le fonctionnement interne du circuit intégré.

D'autres caractéristiques et avantages de l'invention sont donnés dans la description suivante, faite à titre indicatif et non limitatif et en référence aux dessins annexés dans lesquels :

- la figure 1 représente un schéma-bloc général d'un dispositif de détection selon l'invention dans un circuit intégré; et
- la figure 2 est un schéma détaillé d'un exemple de réalisation d'un dispositif de détection selon l'invention.

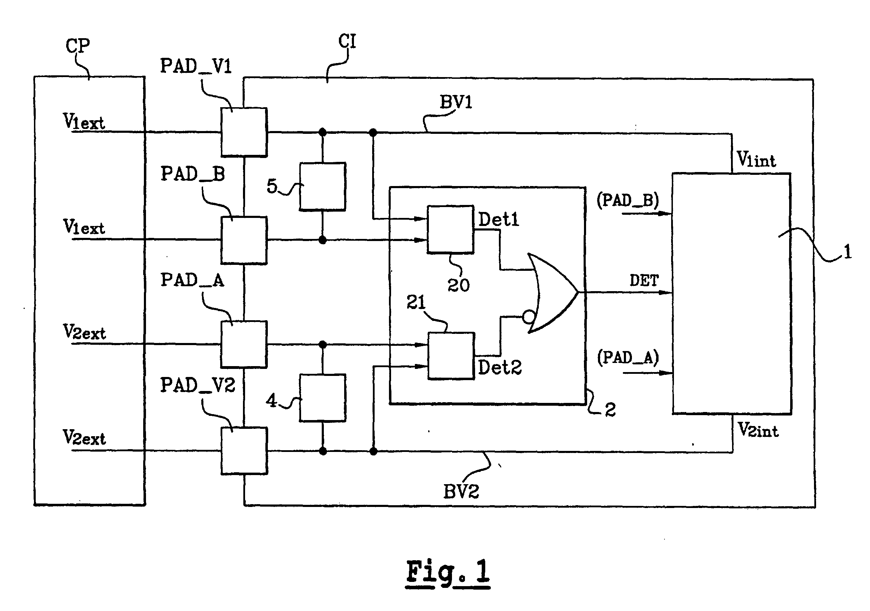

La figure 1 représente un schéma-bloc d'un circuit intégré CI recevant des signaux d'un coupleur CP sur des plots de connexion et comprenant un dispositif de détection selon l'invention.

Le circuit intégré CI comprend un circuit principal 1, un circuit de détection de mauvaise connexion d'alimentation 2 et des plots de connexion. Un premier plot de connexion d'alimentation PAD-V1 est relié à une première ligne d'alimentation logique interne BV1 et reçoit une tension d'alimentation externe V1ext du coupleur CP. Un deuxième plot de connexion PAD-V2 est relié à une deuxième ligne d'alimentation logique interne BV2, et reçoit une tension d'alimentation externe V2ext du coupleur.

On choisit V1ext>V2ext. Ces tensions d'alimentation logique peuvent par exemple correspondre respectivement à une tension d'alimentation logique positive Vdd, par exemple de l'ordre de 3,3 volts, et à la masse Gnd. Mais l'invention ne se limite pas à des niveaux particuliers de tensions d'alimentation logique.

Lorsque les connexions sont de bonne qualité, on obtient sur les lignes d'alimentation interne un niveau interne d'alimentation, V1int et V2int correspondant respectivement aux niveaux des tensions d'alimentation externes appliquées sur les plots d'alimentation, soit V1ext et V2ext.

Le circuit intégré comprend aussi des plots d'entrée/sortie avec dispositif de tirage à l'un des niveaux interne de tension d'alimentation.

Dans l'exemple, on a ainsi un premier plot d'entrée/sortie PAD-A associé à un dispositif de tirage 4 connecté entre ce plot et la deuxième ligne d'alimentation interne BV2. Ce premier plot PAD-A est forcé par défaut par le coupleur CP au niveau de la deuxième tension d'alimentation externe V2ext. Un deuxième plot d'entrée/sortie PAD-B associé à un dispositif de tirage 5 connecté entre ce plot et la première ligne d'alimentation interne BV1. Ce deuxième plot est forcé par défaut par le coupleur au niveau de la première tension d'alimentation externe V1ext.

Dans l'exemple représenté, le dispositif de détection 2 comprend un circuit de détection associé à chaque ligne d'alimentation interne. Un circuit de détection 20 est ainsi connecté en entrées à la première ligne interne d'alimentation BV1 et au deuxième plot d'entrée/sortie PAD-B. Il fournit en sortie un signal de détection Det1, en fonction du niveau de tension d'alimentation interne Vlint sur la ligne d'alimentation interne BV1 et du niveau de tension sur le plot d'entrée/sortie PAD-B. En effet, si la connexion sur le plot d'alimentation PAD-V1 est mauvaise, le niveau de tension sur la ligne interne d'alimentation BV1 est imposé par le dispositif de tirage 5 associé au plot d'entrée/sortie PAD-B. Dans ce cas, le niveau de tension V1int sur la ligne interne d'alimentation BV1 est inférieur au niveau réel de la tension d'alimentation externe V1ext, qui est le niveau de tension obtenu sur le plot PAD-B.

Si la connexion est bonne au contraire, le niveau est sensiblement le même sur la ligne interne d'alimentation BV1 et sur le plot d'entrée/sortie PAD-B.

De même, un circuit de détection 21 est connecté en entrées à la deuxième ligne d'alimentation et au plot d'entrée/sortie PAD-A. Ce circuit fournit en sortie un signal de détection Det2, fonction des niveaux sur les deux entrées. Si la connexion sur le plot d'alimentation PAD-V2 est mauvaise, le niveau de tension V2int sur la ligne interne d'alimentation BV2 est imposé par le dispositif de tirage 4 associé au plot d'entrée/sortie PAD-A. Dans ce cas, le niveau de tension V2int sur la ligne interne d'alimentation BV2 est supérieur au niveau réel de la tension d'alimentation externe V2ext, qui est le niveau de tension obtenu sur le plot PAD-A.

Si la connexion est bonne au contraire, le niveau est sensiblement le même sur la ligne interne d'alimentation et sur le plot d'entrée/sortie.

Dans l'exemple, un signal de sortie DET du dispositif de détection est activé dès lors que l'un au moins des signaux de détection Det1 ou Det2 est activé, indiquant une mauvaise connexion sur l'un au moins des plots d'alimentation logique. Ce signal DET est transmis au circuit principal 1 du circuit intégré, qui le gère en pratique comme un signal d'alarme. Notamment, le circuit principal peut activer des dispositifs de sécurité (non représentés) qui vont bloquer son fonctionnement.

En pratique, un circuit intégré peut comprendre plusieurs plots d'entrée/sortie avec un dispositif de tirage à l'un des niveaux de tension d'alimentation interne. Dans ce cas, on pourra prévoir un circuit de détection par plot d'entrée/sortie existant, permettant d'assurer une couverture optimale en termes de protection du circuit intégré.

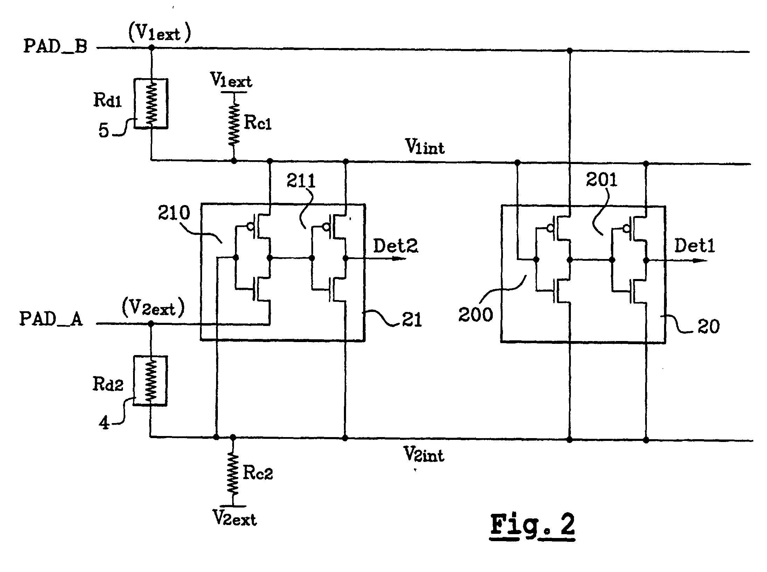

La figure 2 représente un exemple de réalisation de circuits de comparaison utilisés dans un dispositif de protection selon l'invention.

Dans cet exemple, chaque circuit consiste en pratique en au moins deux inverseurs, un premier, pour comparer les niveaux de tension de la ligne interne d'alimentation et du plot d'entrée/sortie, un deuxième pour remettre en forme le signal obtenu et fournir le signal de détection en sortie.

Sur la figure 2, on a représenté les circuits de comparaison 20 et 21 pour les deux lignes internes d'alimentation BV1 et BV2. Dans le cas de la ligne interne d'alimentation BV1, le circuit de comparaison 20 associé permet de détecter que le niveau de tension V1int de cette ligne est inférieur au niveau de tension du plot d'entrée-sortie PAD-B d'environ un seuil de transistor. Dans le cas de la ligne interne d'alimentation BV2, le circuit de comparaison 21 associé permet de détecter que le niveau de tension V2int de cette ligne est supérieur au niveau de tension du plot d'entrée-sortie PAD-A d'environ un seuil de transistor.

Le circuit de comparaison 20 associé à la ligne interne d'alimentation BV1 comprend ainsi un premier inverseur 200 et un deuxième inverseur 201. Le premier inverseur 200 est alimenté entre le plot d'entrée/sortie PAD-B et la ligne interne d'alimentation BV2. L'entrée de cet inverseur est connectée à la ligne interne d'alimentation BV1.

Ainsi, tant que le niveau de la tension d'entrée, c'est à dire le niveau interne d'alimentation V1int reste supérieur ou égal au niveau de la tension du plot PAD-B appliquée comme tension d'alimentation positive de l'inverseur, la sortie de l'inverseur reste au niveau bas. Si le niveau V1int de la tension d'entrée devient inférieur au niveau de la tension du plot PAD-B, la sortie de l'inverseur bascule au niveau haut, ce qui assure la détection selon l'invention. En pratique, il suffit que le niveau V1int devienne inférieur d'un seuil de transistor au niveau de tension du plot PAD-B. De préférence, les transistors de l'inverseur 200 du circuit de comparaison sont choisis pour avoir une tension de seuil la plus faible possible. Le deuxième inverseur 201 est lui alimenté de façon normale, par les deux lignes d'alimentation interne BV1 et BV2 et permet de remettre en forme le signal de sortie du premier inverseur.

De même le circuit de comparaison 21 associé à la ligne interne d'alimentation BV2 comprend ainsi un premier inverseur 210 et un deuxième inverseur 211. Le premier inverseur 210 est alimenté entre la ligne interne d'alimentation BV1 et le plot d'entrée/sortie PAD-A. L'entrée de cet inverseur est connectée à la ligne interne d'alimentation BV2.

Ainsi, tant que le niveau de la tension d'entrée, c'est à dire le niveau interne d'alimentation V2int reste inférieur ou égal au niveau de la tension du plot PAD-A appliquée comme tension d'alimentation négative de l'inverseur, la sortie de l'inverseur reste au niveau haut. Si le niveau V2int de la tension d'entrée devient supérieur au niveau de la tension du plot PAD-A, la sortie de l'inverseur bascule au niveau bas, ce qui assure la détection selon l'invention. En pratique, il suffit que le niveau V2int devienne supérieur d'un seuil de transistor au niveau de tension du plot PAD-A. De préférence, les transistors de l'inverseur 210 du circuit de comparaison est choisi pour avoir une tension de seuil la plus faible possible. Le deuxième inverseur 211 est lui alimenté de façon normale, par les deux lignes d'alimentation interne BV1 et BV2 et permet de remettre en forme le signal de sortie du premier inverseur.

On notera que la logique de sortie des deux circuits de comparaison 20 et 21 est inverse.

D'autres réalisations sont possibles, par exemple avec des amplificateurs différentiels. La réalisation au moyen de simples inverseurs a comme avantage d'être peu coûteuse en place sur le circuit intégré et en prix de revient.

Dans un exemple pratique, les plots d'entrée/ sortie PAD-A et PAD-B permettant l'alimentation interne en cas de connexion défectueuse sur les plots d'alimentation peuvent être des plots pour recevoir des signaux de commande par lesquels le circuit intégré est placé dans un mode de fonctionnement ou dans un autre. Ces plots sont alors par défaut, à des niveaux de tension correspondant à un mode de fonctionnement par défaut. Le changement de mode de fonctionnement du circuit intégré est commandé en imposant sur l'un et/ou l'autre plot un niveau de tension logique différent le temps d'un front ou d'une impulsion horloge. Dans un tel cas, la détection selon l'invention est permanente ou quasi permanente. Un tel fonctionnement correspond notamment au mode de fonctionnement des circuits intégrés destinés aux applications de type carte à puce. Mais l'invention ne s'applique pas exclusivement à ce type de circuit intégré. Elle s'applique à tout circuit intégré comprenant au moins un plot d'entrée/sortie connecté à une ligne interne d'alimentation par un dispositif de tirage, correspondant au niveau de tension par défaut sur ce plot. Notamment, il existe d'autres plots d'entrée/sortie associés à des dispositifs de tirage à l'un des niveaux internes de tension d'alimentation, par exemple le plot de transmission d'horloge, habituellement associé à un dispositif de tirage à la masse ou des plots d'entrée/sortie de donnée, habituellement associés à un dispositif de tirage à la tension d'alimentation logique positive Vdd. Dans ces exemples, le circuit de comparaison associé à un tel plot n'est actif que lorsque le niveau du plot est égal au niveau de tirage.

**Revendications**

**1.** Dispositif de détection de mauvaise connexion d'alimentation dans un circuit intégré comprenant au moins un plot d'alimentation (PAD-V1) associé à une ligne interne d'alimentation correspondante (BV1) du circuit intégré, pour appliquer une alimentation externe (V1ext) sur ladite ligne interne d'alimentation (BV1) du circuit intégré et, pour chaque ligne interne d'alimentation du circuit intégré, au moins un plot d'entrée/sortie (PAD-B) auquel est associé un dispositif de tirage (5) connecté entre ledit plot d'entrée/sortie et la dite ligne d'alimentation interne, **caractérisé en ce que** le dispositif de détection comprend au moins un circuit de comparaison (20, 21) par plot d'alimentation (PAD-V1, PAD-V2) du circuit intégré, un circuit de comparaison étant connecté en entrées à ladite ligne interne d'alimentation et à un plot d'entrée/sortie connecté à ladite ligne par un dispositif de tirage, pour comparer des niveaux de tension entre ledit plot d'entrée/sortie et la dite ligne d'alimentation interne.

**2.** Dispositif selon la revendication 1, **caractérisé en ce qu'**il comprend, pour une ligne interne d'alimentation, plusieurs plots d'entrée/sortie avec un dispositif de tirage connecté entre chacun de ces dits plots et ladite ligne interne d'alimentation, ledit dispositif comprenant un circuit de comparaison pour chacun de ces plots d'entrée/sortie.

**3.** Dispositif de détection selon l'une quelconque des revendications 1 ou 2, **caractérisé en ce qu'**un circuit de comparaison(20) entre les niveaux de tension d'une ligne d'alimentation interne (BV1) et d'un plot d'entrée/sortie (PAD-B) comprend un inverseur (200) alimenté par ledit plot et connecté en entrée à la dite ligne d'alimentation interne.

**4.** Dispositif de détection selon la revendication 3, **caractérisé en ce que** ledit inverseur (200) est formé de transistors.

**5.** Dispositif de détection selon la revendication 3 ou 4, **caractérisé en ce que** ledit circuit de comparaison (20) comprend un autre inverseur (201) en série avec le premier, qui fournit en sortie un signal de détection (Det1).

**6.** Dispositif de détection selon l'une quelconque des revendications précédentes, **caractérisé en ce qu'**il fournit en sortie un signal de détection (DET) appliqué comme signal de blocage du circuit intégré.

**7.** Circuit intégré comprenant un dispositif de détection selon l'une quelconque des revendications précédentes.

**Claims**

**1.** Detection device for a poor power supply connection in an integrated circuit comprising at least one power supply pad (PAD-V1) associated with a corresponding power supply internal line (BV1) of the integrated circuit, for applying an external power supply (V1ext) to the said power supply internal line (BV1) of the integrated circuit and, for each power supply internal line of the integrated circuit, at least one input/output pad (PAD-B) with which is associated a pull device (5) connected between the said input/output pad and the said internal power supply line, **characterized in that** the detection device comprises at least one comparison circuit (20, 21) per power supply pad (PAD-V1, PAD-V2) of the integrated circuit, a comparison circuit being connected as inputs to the said power supply internal line and to an input/output pad connected to the said line by a pull device, for comparing voltage levels between the said input/output pad and the said internal power supply line.

2. Device according to Claim 1, **characterized in that** it comprises, for a power supply internal line, several input/output pads with a pull device connected between each of these said pads and the said power supply internal line, the said device comprising a comparison circuit for each of these input/output pads.

3. Detection device according to any one of Claims 1 to 2, **characterized in that** a comparison circuit (20) for comparing between the voltage levels of an internal power supply line (BV1) and of an input/output pad (PAD-B) comprises an inverter (200) supplied with power by the said pad and connected at input to the said internal power supply line.

4. Detection device according to Claim 3, **characterized in that** the said inverter (200) is formed of transistors.

5. Detection device according to Claim 3 or 4, **characterized in that** the said comparison circuit (20) comprises another inverter (201) in series with the first, which outputs a detection signal (Det1).

6. Detection device according to any one of the preceding claims, **characterized in that** it outputs a detection signal (DET) applied as signal for disabling the integrated circuit.

7. Integrated circuit comprising a detection device according to any one of the preceding claims.

**Patentansprüche**

1. Vorrichtung zur Erfassung eines mangelhaften Versorgungsanschlusses in einem integrierten Schaltkreis mit wenigstens einer Versorgung-Anschlußstelle (PAD-V1), die einer korrespondierenden, internen Versorgungsleitung (BV1) des integrierten Schaltkreises zugeordnet ist, um eine externe Versorgung (V 1ext) auf die interne Versorgungsleistung (BV1) des integrierten Schaltkreises zu legen, und mit wenigstens einem Eingang/Ausgang-Anschluß (PAD-B) für jede interne Versorgungsleitung des integrierten Schaltkreises, der eine Kopiereinrichtung (5) zugeordnet ist, die zwischen den Eingang/Ausgang-Anschluß und der internen Versorgungsleitung geschaltet ist, **dadurch gekennzeichnet, daß** die Erfassungsvorrichtung wenigstens eine Vergleichsschaltung (20, 21) für die Versorgung-Anschlußstelle (PAD-V1, PAD-V2) des integrierten Schaltkreises aufweist, wobei eine Vergleichsschaltung mit den Eingängen der internen Versorgungsleitung und mit einer Eingang/Ausgang-Anschlußstelle verbunden ist, die durch eine Kopiereinrichtung mit dieser Leitung verbunden ist, um die Spannungsniveaus zwischen der Eingang/Ausgang-Anschlußstelle und der betreffenden internen Versorgungsleitung zu vergleichen.

2. Vorrichtung nach Anspruch 1, **dadurch gekennzeichnet, daß** diese für eine interne Versorgungsleitung mehrere Eingang/Ausgang-Anschlußstellen mit einer Kopiereinrichtung aufweist, die zwischen jeder dieser betreffenden Anschlußstellen und der internen Versorgungsleitung geschaltet ist, wobei die Vorrichtung eine Vergleichsschaltung für jede dieser Eingang/Ausgang-Anschlußstellen aufweist.

3. Erfassungsvorrichtung nach einem der Ansprüche 1 oder 2, **dadurch gekennzeichnet, daß** eine Vergleichsschaltung (20) zwischen den Spannungsniveaus einer internen Versorgungsleitung (BV1) und einer Eingang/Ausgang-Anschlußstelle (PAD-B) einen Umschalter (200) aufweist, der von dieser Anschlußstelle versorgt wird und mit dem Eingang der betreffenden internen Versorgungsleitung verbunden ist.

4. Erfassungsvorrichtung nach Anspruch 3, **dadurch gekennzeichnet, daß** der Umschalter (200) aus Transistoren gebildet ist.

5. Erfassungsvorrichtung nach Anspruch 3 oder 4, **dadurch gekennzeichnet, daß** die Vergleichsschaltung (20) einen weiteren Umschalter (201) in Reihe mit dem ersten aufweist, der am Ausgang ein Erfassungssignal (Dep1) liefert.

6. Erfassungsvorrichtung nach einem der vorstehenden Ansprüche, **dadurch gekennzeichnet, daß** diese am Ausgang ein Erfassungssignal (DET) liefert, das als Sperrsignal des integrierten Schaltkreises verwendet wird.

7. Integrierter Schaltkreis mit einer Erfassungsvorrichtung nach einem der vorstehenden Ansprüche.

<u>Fig.1</u>

EP 1 227 329 B1

Det1

201

20

200

V1int

Det2

211

21

210

V1ext

Rc1

Rc2

V2ext

V2int

PAD_B

(V1ext)

Rd1

5

PAD_A

(V2ext)

Rd2

4

**Fig. 2**